# EUROPÄISCHE PATENTANMELDUNG

(11) **EP 0 897 180 A2**
(43) Veröffentlichungstag der Anmeldung: **17.02.1999**
(21) Anmeldenummer: 98111467.1
(22) Anmeldetag: 22.06.1998
(51) Int. Cl.: G11C 11/409

(54) **Schaltungsanordnung für die Bewertung des Dateninhalts von Speicherzellen**

(30) Priorität: 13.08.1997 DE 19735136
(71) Anmelder: SIEMENS AKTIENGESELLSCHAFT, 80333 München (DE)
(72) Erfinder: Brede, Ruediger, 85635 Hoehenkirchen (DE); Savignac, Dominique, Dr., 85737 Ismaning (DE)

(57) **Zusammenfassung**

Die Erfindung betrifft eine Schaltungsanordnung für die Bewertung des Dateninhalts von Speicherzellen (CZ) eines integrierten Halbleiterspeichers, welche Speicherzellen entlang von Bitleitungen (BT, BC) und Wortleitungen (WL) angeordnet sind. Zwischen benachbarten Bitleitungen (BT, BC) ist ein Stromkompensationselement (ST, SC) geschaltet, welches so ausgebildet bzw. angeordnet und/oder durch das Steuersignal (BEWCOMP) derart gesteuert ist und damit der durch das Stromkompensationselement (ST, SC) fließende Kompensationsstrom so eingestellt ist, dass eine sehr schwache NULL bzw. sehr schwache EINS als Dateninhalt einer betroffenen Speicherzelle (SZ) von der Schaltungsanordnung noch als digitale NULL bzw. EINS bewertet ist.

## Beschreibung

Die Erfindung betrifft eine Schaltungsanordnung für die Bewertung des Dateninhalts von Speicherzellen eines integrierten Halbleiterspeichers, welche Speicherzellen entlang von Bitleitungen und Wortleitungen angeordnet sind.

Ein wesentliches Problem bei der Entwicklung und im Betrieb eines DRAM stellt die Rückgewinnung der Information aus einer Speicherzelle dar. Zum Einen ist die Information in einer Zelle durch eine extrem kleine Kapazität repräsentiert, zum Anderen wird diese Kapazität oft noch durch unterschiedlichste Einflüsse reduziert. Diese kleine Ladungsmenge gilt es so zu verstärken, dass die richtige Information rekonstruiert werden kann.

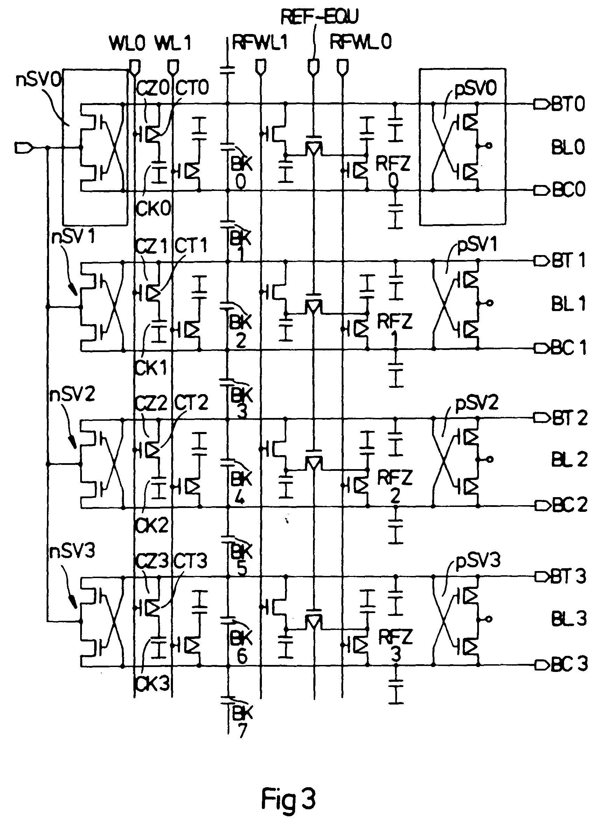

Eine bekannte Schaltungsanordnung der gattungsgemäßen Art wird unter Bezugnahme auf Figur 3 erläutert, welche einen Ausschnitt aus dem Zellenfeld eines DRAM-Halbleiterspeichers zeigt. Dargestellt sind vier Bitleitungspaare BL0, BL1, BL2, BL3 bestehend jeweils aus True-Bitleitungshälften BT0, BT1, BT2, BT3, und Complement-Bitleitungshälften BC0, BC1, BC2, BC3. Jede Speicherzelle CZ0, CZ1, CZ2, CZ3 besitzt eine Zellkapazität CK0, CK1, CK2, CK3, die jeweils an einem Auswahltransistor CT0, CT1, CT2, CT3 angeschlossen ist, über den die Ladungen hinein bzw. heraus gelangen. Jede Zellkapazität ist hierbei mit dem Auswahltransistor über dessen Drainanschluß bzw. Sourceanschluß an der entsprechenden Bitleitungshälfte und über dessen Gateanschluß an einer Wortleitung angeschlossen. Jeder Auswahltransistor CT wird durch eine entsprechende Wortleitung WL0, WL1, ...WL255 ein- bzw. ausgeschaltet. Eine Wortleitung korrespondiert dabei immer mit einer Bitleitungshälfte.

Zu einem Bitleitungspaar gehören je ein p-Kanal-Sense-Verstärker pSV und ein n-Kanal-Sense-Verstärker nSV, welche dem Zweck dienen, das nach Aktivieren der entsprechenden Wortleitung WL auf die entsprechende Bitleitungshälfte geschaltete Zellsignal so zu verstärken, dass eine EINS und eine NULL eindeutig unterschieden werden kann. Die Information von und nach der Zelle fließt über die Bitleitung, an die der Auswahltransistor mit angeschlossen ist. Beim Schreiben gibt es keine Probleme, da hier die Ladung durch die Spannungsversorgung immer maximal der Zelle angeboten wird. Beim Lesen wird nun die Zelle auf die Bitleitung geschaltet. Dadurch ändern sich die Ladungsverhältnisse auf eben dieser Bitleitung. Durch Aktivierung der Sense-Verstärker pSV und nSV wird nun die Ladungsänderung so verstärkt, dass eine EINS oder NULL erkennbar wird. Mit der Aktivierung einer Wortleitung werden alle Zellen dieser Wortleitung an die zugehörigen Bitleitungen geschaltet. Somit wird die Spannung auf der Bitleitung durch die Ladung, die von der Zelle auf die Bitleitung fließt, beeinflusst. Der Einfluss auf die Bitleitungsspannung ist entsprechend dem Kapazitätsverhältnis Zelle zu Bitleitung (etwa 1 : 5) sehr klein. Zwischen allen Bitleitungen befinden sich parasitäre BL-BL-Kapazitäten BK0, BK1, BK2, BK3, BK4, BK5, BK6, BK7.

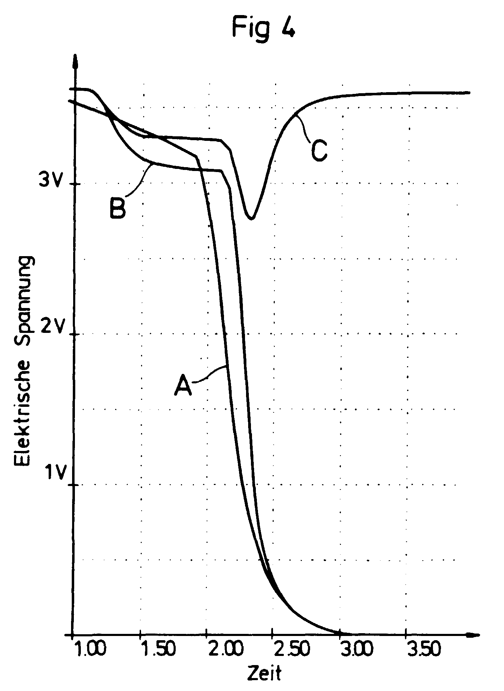

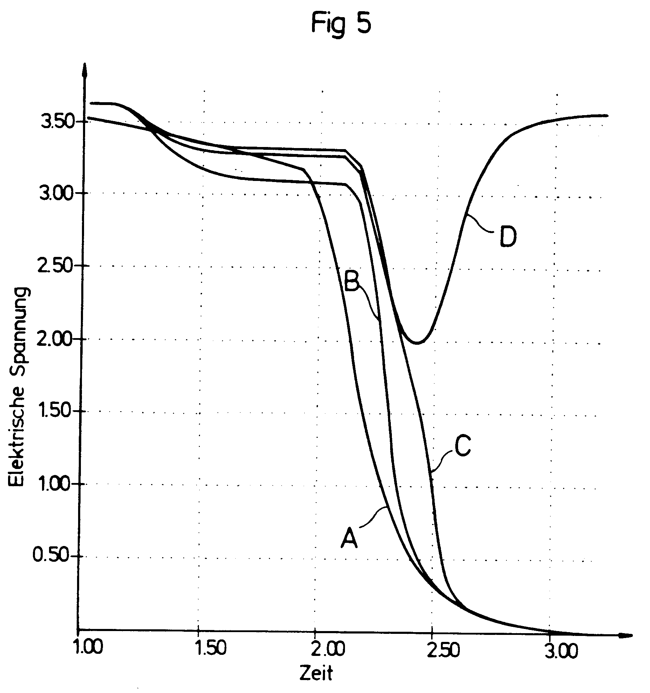

Im Einzelnen ist ein Lesevorgang wie folgt. Während einer Precharge-Zeit werden die Bitleitungen auf eine definierte Spannung vorgeladen, beispielsweise auf VDD = 3,6 V. Daran anschließend wird beim Lesen eine Wortleitung aktiv geschaltet, beispielsweise die Wortleitung WL0. Angenommen, in den Zellen CZ0, CZ1, CZ2 und CZ3 stehen jeweils NULLen. Die Normalspannung für eine NULL ist beispielsweise 1,2 V, die Normalspannung für eine EINS ist 3,6 V, die Normalspannung der Referenzzelle RFZ beträgt dann in etwa 2,6 V. Im Folgenden wird nun angenommen, dass die Zelle CZ2 eine schwache Zelle ist, beispielsweise verursacht durch einen hohen Leckstrom und daher eine NULLspannung von 2,2 V besitzt (bei einer anderen Annahme wäre beispielsweise die Kapazität der Zelle CZ2 etwas kleiner als der Zellkapazitätsdurchschnitt. Eine solche Annahme würde zu ähnlichen Ergebnissen führen). Figur 4 zeigt eine Simulation der Bewertung (Lesen) einer normalen NULL (1,2 V), und Figur 5 die Simulation der Bewertung einer schwachen NULL (2,2 V) der Zelle CZ2. Dargestellt ist jeweils der Verlauf der Spannung in Volt in Abhängigkeit der Zeit (willkürliche Einheiten). Die Kurve A zeigt den Spannungsverlauf des Signals SETN, welches die Bewertung startet. Die Kurve B zeigt den Spannungsverlauf der Bitleitungen BT0, BT1, BT3, die mit einer Zelle verbunden sind, in denen eine Normalnull (1,2 V) gespeichert ist. Die Kurve C zeigt den Spannungsverlauf der Bitleitungen BC0, BC1, BC3, die mit den Referenzzellen RFZ0, RFZ1, RFZ3 (2,6 V) verbunden sind. In Figur 5 bezeichnet die Kurve D den Spannungsverlauf der Bitleitung BT2, die mit der Zelle CZ2 verbunden ist, in der eine schwache NULL (2,2 V) gespeichert ist. Man erkennt aus der Simulation nach Figur 5, dass die schwache NULL der Zelle CZ2 falsch bewertet wird, da die Bitleitung BT2 während der Bewertung auf 3,6 V heraufgeht, obwohl die Spannung der Referenzzelle RFZ2 um 0,4 Volt größer ist (2,6 V). Die Ursache für diese falsche Bewertung liegt in den parasitären BL-BL-Kapazitäten BK. Gemäß Figur 5 zieht die Bitleitung BT3 gewissermaßen während der Bewertung über die parasitäre BL-BL-Kapazität BK5 an der Bitleitung BC2. Dadurch wird auf die Bitleitung BC2 eine negative Spannung eingekoppelt, durch welche die Spannung von BC2 unterhalb der Spannung von BT2 sinkt, wodurch letztendlich eine falsche Bewertung entsteht.

In vielen bisher bekannten Entwürfen werden die bei einer Bewertung des Zellsignals (Sensing) auf den benachbarten Bitleitungen infolge von kapazitiven Kopplungen entstehenden Störungen toleriert. Diese Entwürfe erfordern jedoch eine größere Zellkapazität. Andere Entwürfe verwenden sogenannte twisted Bitlines, welche jedoch wertvolle Chipfläche beanspruchen.

Der Erfindung liegt daher die Aufgabe zugrunde, eine Schaltungsanordnung der gattungsgemäßen Art dahingehend zu verbessern, dass eine sichere Bewertung auch schwacher Speicherzellen ermöglicht ist, ohne die Zellkapazität zu vergrößern, oder besonders angeordnete Bitleitungen, die zusätzliche Chipfläche erfordern, zu verwenden.

Diese Aufgabe wird durch eine Schaltungsanordnung nach Anspruch 1 gelöst.

Erfindungsgemäß ist zwischen benachbarten Bitleitungen ein Stromkompensationselement geschaltet, welches so ausgebildet bzw. angeordnet und/oder durch das Steuersignal (BEWCOMP) derart gesteuert ist, und damit der durch das Stromkompensationselement fließende Kompensationsstrom so eingestellt ist, dass eine sehr schwache NULL bzw. sehr schwache EINS als Dateninhalt einer betroffenen Speicherzelle von der Schaltungsanordnung noch als digitale NULL bzw. EINS bewertet ist.

Hierbei ist das Stromkompensationselement insbesondere durch einen steuerbaren Schalter, vorzugsweise einen Kompensationstransistor gebildet, dessen Elektrodenanschlüsse (Drain bzw. Source) jeweils an unmittelbar benachbarte Bitleitungen angeschlossen sind, und zwar sind dessen Elektrodenanschlüsse (Drain bzw. Source) jeweils an einer Bitleitung True (bzw. einer Bitleitung Complement) und der benachbarten Bitleitung True (bzw. der benachbarten Bitleitung Complement) angeschlossen, und dessen Steueranschluss (Gate) mit einem Kompensationssteuersignal beaufschlagt ist. Dem Prinzip der Erfindung folgend ist das Stromkompensationselement derart eingestellt, dass die Stromkompensation für alle möglichen Bitmuster auf den Bitleitungen gute Ergebnisse liefert.

Vorteilhafte Weiterbildungen der Erfindung ergeben sich aus den Unteransprüchen.

Nachfolgend wird die Erfindung anhand eines in der Zeichnung dargestellten Ausführungsbeispiels weiter erläutert. Im Einzelnen zeigen die schematischen Darstellungen in:
- Figur 1: einen Ausschnitt aus einem Zellenfeld einer synchronen DRAM-Halbleiterspeichereinrichtung mit einer erfindungsgemäßen Schaltungsanordnung für die Bewertung des Dateninhalts von Speicherzellen;
- Figur 2: den zeitlichen Spannungsverlauf beim Lesen einer schwachen NULL mit der erfindungsgemäßen Schaltungsanordnung nach Figur 1;
- Figur 3: einen schematischen Ausschnitt aus einem Zellenfeld einer bisherigen DRAM-Halbleiterspeichereinrichtung;
- Figur 4: die Simulation einer Bewertung einer normalen NULL; und
- Figur 5: die Simulation der Bewertung einer schwachen NULL vermittels einer bisherigen Schaltungsanordnung.

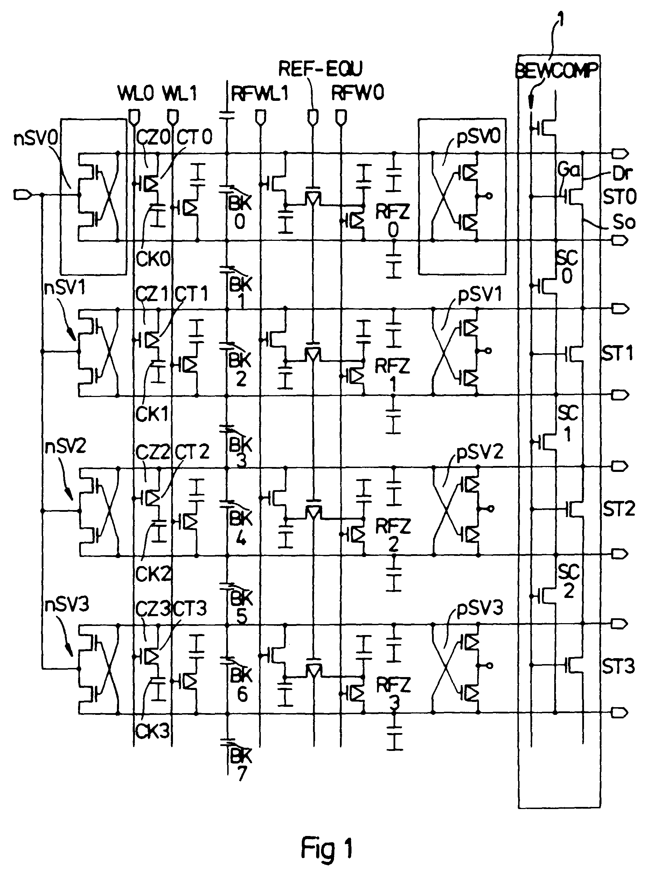

Bei dem in Figur 1 dargestellten Ausführungsbeispiel einer erfindungsgemäßen Schaltungsanordnung bezeichnen gleiche Bezugsziffern gleiche Komponenten wie bei der eingangs gemäß Figur 3 beschriebenen Schaltung, so dass deren Erläuterung nicht wiederholt wird. Im Unterschied zur Anordnung nach Figur 3 und entsprechend dem Wesen der Erfindung besitzt die Schaltungsanordnung nach Figur 1 eine Kompensationseinrichtung 1 mit jeweils zwischen benachbarten Bitleitungen gekoppelten Stromkompensationselementen ST und SC. Im Einzelnen sind jeweils zwischen benachbart aufeinanderfolgenden True-Bitleitungen BT0, BT1, BT2, BT3 angeschlossene True-Stromkompensationselemente in Form von n-Kanal-Enhancement-MOSFET-Transistoren ST0, ST1, ST2, ST3 vorgesehen, deren Drain-Anschlüsse Dr mit den dazugehörenden True-Bitleitungshälften BT usw., und deren Source-Anschlüsse So mit den darauffolgenden True-Bitleitungshälften BT1 usw. verbunden sind, und deren Gate-Anschlüsse Ga mit einem Steuersignal BEWCOMP beaufschlagt sind. Weiterhin sind Complement-Stromkompensationselemente in Form von n-Kanal-Enhancement-MOSFET-Transistoren SC0, SC1, SC2, SC3 vorgesehen, deren Drain-Anschlüsse Dr an die zugehörigen Bitleitungshälften BC0 usw., und deren Source-Anschlüsse So an die unmittelbar darauffolgenden Bitleitungshälften BC1 usw. angeschlossen sind, und deren Gate-Anschlüsse Ga gleichfalls mit demselben Steuersignal BEWCOMP beaufschlagt sind. Sämtliche n-Kanal-Enhancement-MOSFET-Transistoren ST und SC besitzen jeweils eine Einsatzspannung von etwa 0,6 V.

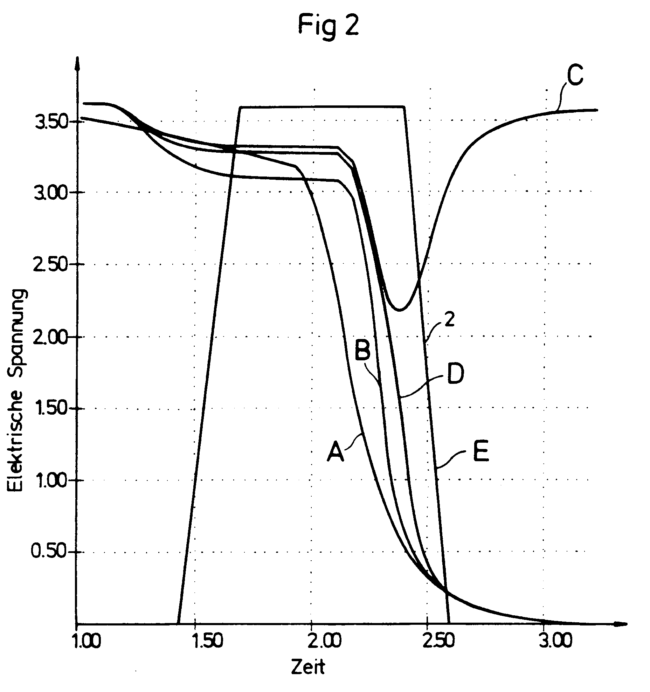

Die Funktionsweise der erfindungsgemäßen Schaltungsanordnung nach Figur 1 geht aus der schematischen Bewertungsdarstellung einer schwachen NULL gemäß Figur 2 hervor. Die Kurve A bezeichnet wiederum den Spannungsverlauf des Signals SETN, die Kurve C den auf der Bitleitung BC2 gemessenen Spannungsverlauf, die Kurve D den Spannungsverlauf der Bitleitung BT2, die mit einer Speicherzelle CZ2 verbunden ist, in der eine schwache NULL (2,2 V) gespeichert ist, und die Kurve E den Spannungsverlauf des Steuersignals BEWCOMP. Wie aus Figur 2 ersichtlich ist, wird die schwache NULL der Speicherzelle CZ2 (2,2 V Zellspannung) nun richtig bewertet, d.h. die Bitleitung BT2 geht auf Null V. Die Bitleitung BT3 zieht auch jetzt während der Bewertung über die parasitäre BL-BL-Kapazität BK5 an der Bitleitung BC2. Bei der erfindungsgemäßen Schaltungsanordnung zieht die Bitleitung BT3 nun aber gleichzeitig über den n-Kanal-Enhancement-MOSFET-Transistor ST2 an der Bitleitung BT2, d.h. es fließt, während die Spannung des Signals SETN auf Null geht, ein Kompensationsstrom von der Bitleitung BT2 zur Bitleitung BT3. Darüber hinaus fließt ein etwa gleich großer Kompensationsstrom von BT2 nach BT1 über den MOSFET-Transistor ST1. Des Weiteren fließen noch zwei kleinere Kompensationsströme von BC3 nach BC2 und von BC1 nach BC2. Entweder über die Parameter der Transistoren ST1, SC1, ST2, SC2 oder über den Spannungsverlauf des Steuersignals BEWCOMP kann dieser Kompensationsstrom nun so eingestellt werden, dass eine sehr schwache NULL, beispielsweise 2,2 V Zellspannung bei einer Referenzzellspannung von 2,6 V, gerade noch als NULL erkannt wird. Bei einer Überkompensation, d.h. die Transistoren sind zu groß gewählt, würde eine schwache EINS (2,7 V Zellspannung) als NULL bewertet werden. Die Transistoren ST1, SC1, ST2, SC2 sollten durch das Signal BEWCOMP sofort abgeschaltet werden, sobald das Signal SETN der Spannung Null Volt nahekommt, um einen Kurzschluss-Strom zu vermeiden. Die ansteigende Flanke 1 des Steuersignals BEWCOMP ist dagegen zeitunkritisch, da der Transistor ST2 erst leitfähig wird, nachdem die Bitleitungen um mehr als 0,6 V unter den Wert der Versorgungsspannung VDD gesunken sind.

Die vorstehend erläuterte Stromkompensation sollte für alle möglichen Bitmuster auf den Bitleitungen gute Ergebnisse liefern:

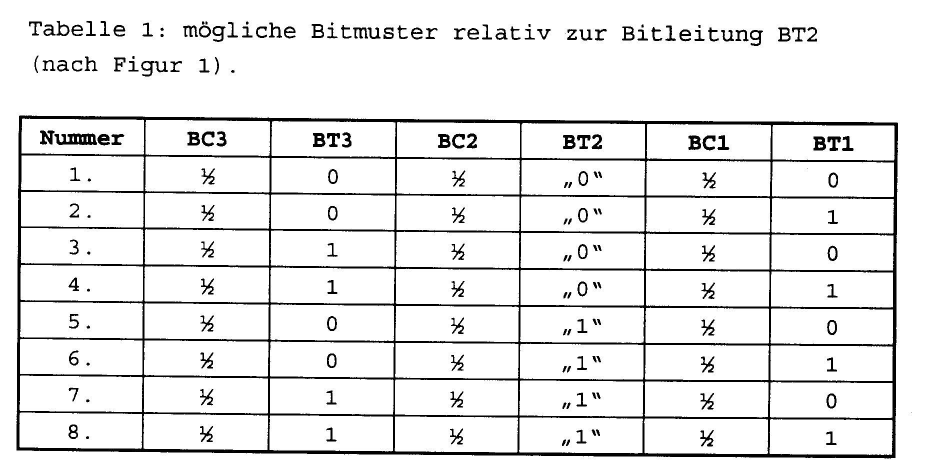

Hierbei bezeichnen die in der Tabelle verwendeten 0, 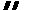 0", ½, 1, 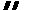 1" das folgende:
0 bedeutet: auf die betreffende Bitleitungshälfte wird eine Zelle geschaltet, in der eine NULL steht.
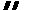 0" bedeutet: auf die betreffende Bitleitungshälfte (BT2) wird eine Zelle geschaltet, in der eine schwache NULL steht.
½ bedeutet: auf die betreffende Bitleitungshälfte wird eine Referenzzelle geschaltet.
1 bedeutet: auf die betreffende Bitleitungshälfte wird eine Zelle geschaltet, in der eine EINS steht.
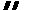 1" bedeutet: auf die betreffende Bitleitungshälfte (BT2) wird eine Zelle geschaltet, in der eine schwache EINS steht.

Das Bitmuster 1. nach der Tabelle 1 entspricht dem obig ausführlich untersuchten Fall, für den mit der Schaltungsanordnung nach Figur 1 die kapazitive BL-BL-Störung kompensiert wurde. Bei dem Bitmuster 2, neutralisieren sich die kapazitiven BL-BL-Störungen auf die Bitleitung 2, da die Störung von BT3 auf BC2 gleich der Störung von BC1 auf BT2 ist (BT3 und BC1 gehen auf Null). Die Kompensationsströme durch die Transistoren ST1, SC1, ST2, SC2 neutralisieren sich hier ebenfalls. Bei dem Bitmuster 3, neutralisieren sich die kapazitiven BL-BL-Störungen auf die Bitleitung 2 ebenfalls bzw. sind annähernd Null (BT3 und BC1 bleiben auf Eins). Die Kompensationsströme durch die Transistoren ST1, SC1, ST2, SC2 neutralisieren sich ebenfalls wieder. Bei dem Bitmuster 4. wirken die Kompensationsströme durch die Transistoren ST1, ST2, SC1, SC2 zwar in die falsche Richtung, was aber hier nicht stört, da hierdurch nur die in diesem Falle positive kapazitive BL-BL-Kopplung von BC1 auf BT2 kompensiert wird (BC1 geht auf Null und unterstützt so über die parasitäre BL-BL-Kapazität die schwache NULL auf BT2). Für die Bitmuster 5. bis 8. gelten ähnliche Zusammenhänge. Die Schaltungsanordnung nach Figur 1 kompensiert somit die kapazitiven Kopplungen zwischen benachbarten Bitleitungen während der Bewertung durch Kompensationsströme von jeder Bitleitung zur nächsten Bitleitung.

Im Rahmen der Erfindung ist es ebenso möglich, für die Stromkompensation andere Transistoren als n-Kanal-Enhancement-Transistoren einzusetzen, beispielsweise p-Kanal-Enhancement-Transistoren, zusammen mit einem angepassten Signalverlauf für das Steuersignal BEWCOMP.

Mit der Erfindung werden auch noch sehr schwache NULLen (Zellspannung 2,5 V und weniger) richtig bewertet. Der Zellspannungsgewinn beträgt etwa 0,4 V. Die Differenzspannung zwischen einer starken NULL (1,2 V) und der Referenzzellspannung (2,6 V) beträgt 1,4 V. Mit der Schaltungsanordnung gemäß Figur 3 sind davon aber nur 0,9 V nutzbar (die Null fällt bei der Schaltungsanordnung nach Figur 3 schon bei einer Zellspannung von 2,2 V aus). Mit der erfindungsgemäßen Schaltungsanordnung nach Figur 1 vergrößert sich hingegen der nutzbare Spannungsbereich auf 1,3 V; die NULL wird noch bei 2,5 V richtig bewertet. Der nutzbare Spannungsbereich vergrößert sich also um etwa 44 %, wobei dieser Wert von der Größe der parasitären BL-BL-Kapazität und der Größe der parasitären Bitleitungskapazität abhängig ist. Je größer das Verhältnis von der parasitären BL-BL-Kapazität zur parasitären Bitleitungskapazität ist, desto größer ist die durch Stromkompensation erzielbare Verbesserung bei der Bewertung.

Weiterhin eröffnet die Erfindung auch die Möglichkeit, die beim Auslesen der Zellen entstehenden kapazitiven Störungen zwischen den Bitleitungen zu kompensieren, wobei hierzu der Spannungsverlauf des Steuersignals BEWCOMP etwas variiert wird.

Bei dem in Figur 1 dargestellten Ausführungsbeispiel sind jeder Bitleitung Referenzzellen RFZ zugeordnet, und zwar jeweils für eine Gruppe von beispielsweise 256 Wortleitungen WL0 bis WL255. Diese Referenzzellen dienen in an sich bekannter Weise der Einstellung einer mittleren Referenzspannung beim Lesevorgang durch die Senseverstärker. Die erfindungsgemäße Stromkompensationsschaltung lässt sich in gegebenenfalls leicht modifizierter Anordnung auch in solchen Entwürfen anwenden, bei denen die Bitleitungen nur auf die halbe Array-Spannung vorgeladen werden (beispielsweise VDD/2), und in denen daher keine Referenzzellen notwendig sind.

Als weiteren Vorteil könnten bei einer Anwendung der erfindungsgemäßen Stromkompensationsanordnung die Zellkapazitäten reduziert werden; alternativ könnte man bei unveränderter Zellkapazität eine verbesserte Retentions-Zeit erhalten.

## Patentansprüche

1. Schaltungsanordnung für die Bewertung des Dateninhalts von Speicherzellen (CZ) eines integrierten Halbleiterspeichers, welche Speicherzellen entlang von Bitleitungen (BT, BC) und Wortleitungen (WL) angeordnet sind,
dadurch **gekennzeichnet**,
dass zwischen benachbarten Bitleitungen (BT, BC) ein Stromkompensationselement (ST, SC) geschaltet ist.

2. Schaltungsanordnung nach Anspruch 1,
dadurch **gekennzeichnet**,
dass das Stromkompensationselement (ST, SC) durch einen vermittels eines Steuersignals (BEWCOMP) steuerbaren Schalter gebildet ist.

3. Schaltungsanordnung nach Anspruch 1 oder 2,
dadurch **gekennzeichnet**,
dass das Stromkompensationselement (ST, SC) so ausgebildet bzw. angeordnet und/oder durch das Steuersignal (BEWCOMP) derart gesteuert ist und damit der durch das Stromkompensationselement (ST, SC) fließende Kompensationsstrom so eingestellt ist, dass eine sehr schwache NULL bzw. sehr schwache EINS als Dateninhalt einer betroffenen Speicherzelle (SZ) von der Schaltungsanordnung noch als digitale NULL bzw. EINS bewertet ist.

4. Schaltungsanordnung nach einem der Ansprüche 1 bis 3,
dadurch **gekennzeichnet**,
dass jede Bitleitung aus einem Paar komplementärer Bitleitungshälften (BT, BC) besteht, die gemeinsam an eine Senseverstärkereinrichtung (pSV, nSV) angeschlossen sind.

5. Schaltungsanordnung nach einem der Ansprüche 1 bis 4,
dadurch **gekennzeichnet**,
dass jede Speicherzelle (SZ) eine Zellkapazität (CK) und einen der Zellkapazität zugeordneten Auswahltransistor (CT) aufweist, dessen Elektrodenanschlüsse (Drain bzw. Source) jeweils an einer Bitleitungshälfte (BT, BC) und dessen Steueranschluss (Gate) an einer Wortleitung (WL) angeschlossen ist.

6. Schaltungsanordnung nach einem der Ansprüche 1 bis 5,
dadurch **gekennzeichnet**,
dass die Senseverstärkereinrichtung (pSV, nSV) einen p-Kanal- und einen n-Kanal-Senseverstärker aufweist.

7. Schaltungsanordnung nach einem der Ansprüche 1 bis 6,
dadurch **gekennzeichnet**,
dass die Stromkompensationselemente (ST, SC) wechselweise an die Bitleitungshälften (BT, BC) der Bitleitungen angeschlossen sind.

8. Schaltungsanordnung nach einem der Ansprüche 1 bis 7,
dadurch **gekennzeichnet**,
dass die Stromkompensationselemente (ST, SC) durch ein einziges Steuersignal (BEWCOMP) gesteuert sind.
